# EUROPEAN PATENT APPLICATION

(11) **EP 2 385 334 A1**
(43) Date of publication of application: **09.11.2011**
(21) Application number: 10250884.3
(22) Date of filing: 06.05.2010
(51) Int. Cl.: F28F 13/00

(54) **Thermal conducting principle and device for prestressed clamping type multi-layered structure**

(71) Applicant: Yang, Tai-Her, Si-Hu Town Dzan-Hwa (TW)
(72) Inventor: Yang, Tai-Her, Si-Hu Town Dzan-Hwa (TW)
(74) Representative: Wright, Howard Hugh Burnby

(57) **Abstract**

The present invention discloses that the relay thermal conductor (102) being made of material having better thermal conductivity coefficient is heat transfer coupled with the heating or cooling first thermal body (101) at one end or face thereof, and is coupled with interface thermal conductor (103) having higher specific heat capacity at the other end or face thereof, wherein the interface thermal conductor (103) having higher specific heat capacity is the heat transfer carrier between relay thermal conductor (102) and second thermal body (104).

## Description

### BACKGROUND OF THE INVENTION

### (a) Field of the invention

The invention discloses that the relay thermal conductor with better thermal conductivity coefficient and the interface thermal conductor having both or at least one of the specific heat capacity or thermal emissivity better than the relay thermal conductor are commonly integrated to form a prestressed clamping thermal conducting or heat dissipating structure having at least two layers in particular combination type thereby avoiding loosening or deformation of the multi-layer structure material due to different coefficients of thermal expansion to result in poor thermal conducting surface unfavorable for thermal conduction.

### (b) Description of the Prior Art

Conventional cooling or heating device with multi-layer structure constituted by various materials often resulted in loosening or deformation due to different thermal conductivity coefficients subject to different materials, thus resulted in poor thermal conducting surface unfavorable for thermal conduction.

### SUMMARY OF THE INVENTION

The invention innovatively discloses a thermal conducting principle and device for prestressed-clamping type multi-layered structure, wherein the multi-layered thermal conducting or heat dissipating structure is made of materials with different thermal characteristics and is different from the conventional thermal conducting or heat dissipating structure being made of single material, wherein for the thermal conducting principle and device for prestressed-clamping type multi-layered structure of present invention, the relay thermal conductor being made of material with better thermal conductivity coefficient is heat conductively coupled with the heating or cooling first thermal body at one end or surface thereof, and is coupled with the interface thermal conductor at the other end or surface thereof, and the interface thermal conductor having the thermal conducting characteristics with both or at least one of the 1) higher specific heat capacity relative to relay thermal conductor, or 2) better thermal emissivity to second thermal body relative to relay thermal conductor is used as the heat conducting carrier between relay thermal conductor and second thermal body, and is favorable for thermal energy conduction when there is temperature difference between first thermal body and second thermal body; in addition, the present invention further discloses that each structure layer being in prestressed-clamping type combined structure to reduce volume has the prestressed clearance (500) for producing clamping or outwardly expanding prestressing force to ensure good thermal conducting contact and avoid loosening or deformation of the multi-layer structure material due to different coefficients of thermal expansion to result in poor thermal conducting surface unfavorable for thermal conduction.

### BRIEF DESCRIPTION OF THE DRAWINGS

Fig. 1 is a structural schematic view of the present invention showing that the first thermal body being constituted by the thermal conducting casing at heat release end or heat absorbing end of heat pipe is prestressed-clampingly combined.
Fig. 2 is a top schematic view of Fig. 1.
Fig. 3 is a structural schematic view of the present invention showing that the thermal conduction coupling and combined surface between relay thermal conductor (102) and interface thermal conductor (103) is concavely and convexly prestressed-clampingly combined.
Fig. 4 is a structural schematic view of the present invention showing that the thermal conduction coupling and combined surface between relay thermal conductor (102) and interface thermal conductor (103) is prestressed-clampingly combined.
Fig. 5 is a structural schematic view of the present invention showing that the thermal conduction coupling and combined surface between relay thermal conductor (102) and interface thermal conductor (103) is prestressed-clampingly dovetailed.
Fig. 6 is a structural schematic view of the present invention showing that the thermal conduction coupling and combined surface between relay thermal conductor (102) and interface thermal conductor (103) is T-slot prestressed-clampingly combined.
Fig. 7 is a structural schematic view of the present invention showing that the thermal, conduction coupling and combined surface between relay thermal conductor (102) and interface thermal conductor (103) is prestressed-clampingly combined by stud/hole fastening.
Fig. 8 is a structural schematic view of the present invention showing that the thermal conduction coupling and combined surface between relay thermal conductor (102) and interface thermal conductor (103) is concavely and convexly prestressed-clampingly combined by multi-fins.
Fig. 9 is a structural schematic view showing the prestressed-clamping structure of the present invention which is installed with thermal conductive interlayer (110), relay thermal conductor (102) and interface thermal conductor (103), and uses the thermal conducting casing at heat release or heat absorbing end of the heat pipe as the first thermal body.
Fig. 10 is a top view of Fig. 9.
Fig. 11 is a structural schematic view of the present invention showing that the thermal conduction coupling and combined surfaces between thermal conductive interlayer (110) and relay thermal conductor (102) and interface thermal conductor (103) are concavely and convexly prestressed-clampingly combined.
Fig. 12 is a structural schematic view of the present invention showing that the thermal conduction coupling and combined surfaces between thermal conductive interlayer (110) and relay thermal conductor (102) and interface thermal conductor (103) are prestressed-clampingly combined.
Fig. 13 is a structural schematic view of the present invention showing that the thermal conduction coupling and combined surfaces between thermal conductive interlayer (110) and relay thermal conductor (102) and interface thermal conductor (103) are prestressed-clampingly dovetailed.
Fig. 14 is a structural schematic view of the present invention showing that the thermal conduction coupling and combined surfaces between thermal conductive interlayer (110) and relay thermal conductor (102) and interface thermal conductor (103) are T-slot prestressed-clampingly combined.
Fig. 15 is a structural schematic view of the present invention showing that the thermal conduction coupling and combined surfaces between thermal conductive interlayer (110) and relay thermal conductor (102) and interface thermal conductor (103) are prestressed-clampingly combined by stud/hole fastening.
Fig. 16 is a structural schematic view of the present invention showing that the thermal conduction coupling and combined surfaces between thermal conductive interlayer (110) and relay thermal conductor (102) and interface thermal conductor (103) are concavely and convexly prestressed-clampingly combined by multi-fins.
Fig. 17 is a schematic view of the application example showing that heat receiving surface of relay thermal conductor (102) transfers neighboring cooking device of combustion state heat generator.

### DESCRIPTION OF MAIN COMPONENT SYMBOLS

100: Thermal conducting or heat dissipating assembled structure
101: First thermal body
102: Relay thermal conductor
103: Interface thermal conductor
104: Second thermal body
110: Thermal conductive interlayer
500: Clearance

### DETAILED DESCRIPTION OF THE PREFERRED EMBODIMENT

The present invention discloses a relay thermal conductor made of good thermal conducting characteristics with the first thermal body for executing non-closed type thermal conducting coupling with the first thermal body, and an interface thermal conductor is installed between relay thermal conductor and second thermal body for coupling between second thermal body and relay thermal conductor for conducting thermal energy between the two. The interface thermal conductor having the thermal conducting characteristics with both or one of the 1) higher specific heat capacity relative to relay thermal conductor, or 2) better thermal emissivity to second thermal body relative to relay thermal conductor is used as the heat conducting carrier between relay thermal conductor and second thermal body, as well as to avoid loosening or deformation of the multi-layer structure material due to different coefficients of thermal expansion to result in poor thermal conducting surface unfavorable for thermal conduction.

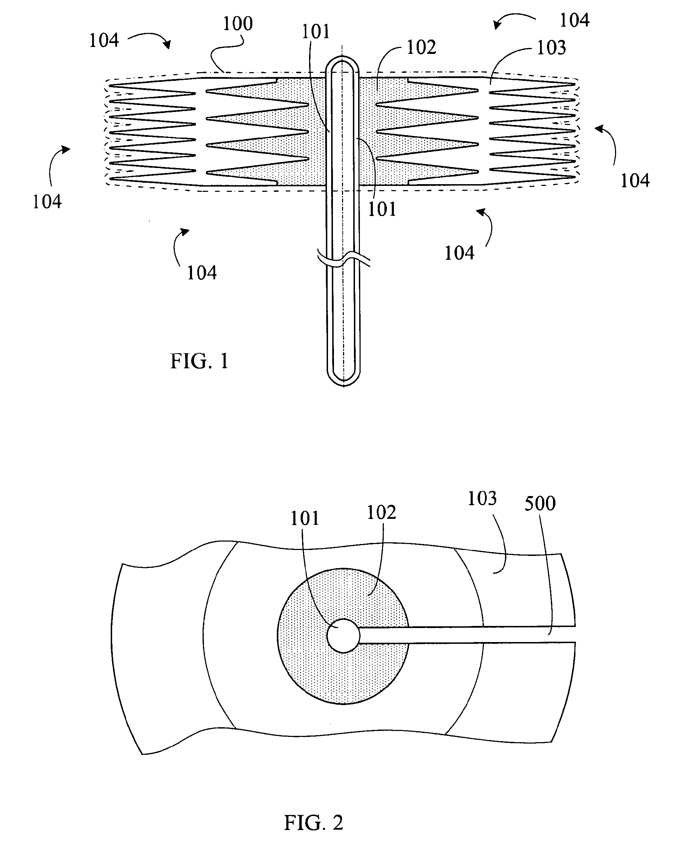

The thermal conducting principle and device for prestressed-clamping type multi-layered structure of present invention is as shown in Fig. 1, wherein Fig. 1 is a structural schematic view of the present invention showing that the first thermal body being constituted by the thermal conducting casing at heat release end or heat absorbing end of heat pipe is prestressed-clampingly combined, wherein it mainly comprises:
□□ The thermal conducting or heat dissipating assembled structure (100) being constituted by at least two layers of thermal conducting material having different thermal characteristics, wherein the relay thermal conductor (102) having better thermal conductivity coefficient is coupled with the first thermal body (101), and the interface thermal conductor (103) having higher thermal capacity is coupled between the relay thermal conductor (102) and the second thermal body (104) thereby constituting the thermal conducting or heat dissipating assembled structure (100);

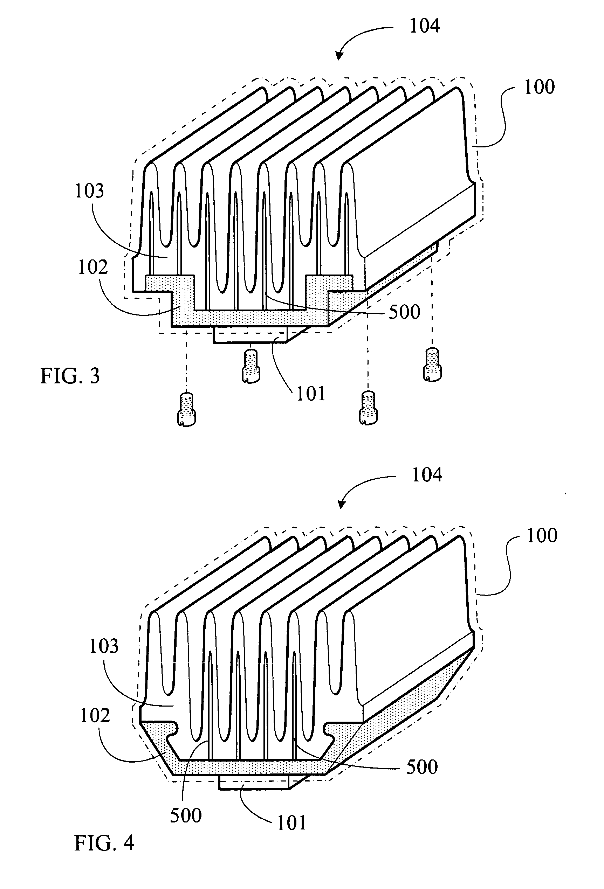

The thermal conducting or heat dissipating assembled structure (100) is installed between first thermal body (101) and second thermal body (104); wherein thermal conducting or heat dissipating assembled structure (100) is constituted by relay thermal conductor (102) and interface thermal conductor (103), wherein
□□ The first thermal body (101): It is an active cooling or heating, or passive heat absorbing or releasing thermal body constituted by non-closed solid, gaseous, liquid state material or colloidal or powder type matters; or the thermal body being constituted by thermal conducting casing at the heat release end or heat absorbing end of heat pipe;
□□ The relay thermal conductor (102): The relay thermal conductor is constituted by at least one layer of solid, gaseous, liquid state material or colloidal or powder type matters having a better thermal conductivity coefficient, wherein the relay thermal conductor (102) is contact combined with the open first thermal body (101) at one end or surface thereof, and is combined with the interface thermal conductor (103) at the other end or surface thereof for thermal energy conduction includes that the relay thermal conductor (102) is installed between the first thermal body (101) being constituted by the thermal conducting casing at heat release end or heat absorbing end of heat pipe and the interface thermal conductor (103) for thermal energy conduction (refer to Figs. 1, 2), or the relay thermal conductor (102) in prestressed-clamping combination is installed between the first thermal body (101) constituted by thermal conducting casing of thermal fluid conducting pipe and the interface thermal conductor (103) for thermal energy conduction (Refer to Fig. 3); the thermal conductivity coefficient of the relay thermal conductor and the first thermal body (101) is better than the one of the interface thermal conductor (103), i.e. its thermal conducting rate is faster than the one of interface thermal conductor (103), and the thermal conduction coupling surface areas of relay thermal conductor (102) and interface thermal conductor (103) are larger or equal to the thermal conduction coupling surface area of relay thermal conductor (102) and first thermal body (101);
□□ The interface thermal conductor (103): It is constituted by at least one layer of solid, gaseous, liquid state material or colloidal or powder type matters having the thermal conducting characteristics with both or at least one of the 1) specific heat capacity , or 2) thermal emissivity to second thermal body (104), better than the one of the relay thermal conductor (102), wherein the interface thermal conductor (103) being installed between the relay thermal conductor (102) and the second thermal body (104) for thermal energy conduction includes that the first thermal body (101) being constituted by the thermal conducting casing at heat release end or heat absorbing end of heat pipe is installed with the relay thermal conductor (102) in prestressed-clamping combination, and the interface thermal conductor (103) is installed between the relay thermal conductor (102) and the second thermal body (104) for thermal energy conduction (refer to Figs. 1, 2); or the first thermal body (101) being constituted by the thermal conducting casing of thermal energy fluid piping is installed with the relay thermal conductor (102), and the interface thermal conductor (103) is installed between the relay thermal conductor (102) and the second thermal body (104) for thermal energy conduction (refer to Fig. 3); the thermal conduction coupling surface area between the interface thermal conductor (103) and the second thermal body (104) is larger or equal to the thermal conduction coupling surface area between the relay thermal conductor (102) and the interface thermal conductor (103);

Each structure layer is in prestressed-clamping type combined structure to reduce volume and has a prestressed clearance (500) to produce clamping or outwardly expanding prestressing force to ensure good thermal conducting contact, and to avoid loosening or deformation of the multi-layer structure material due to different coefficients of thermal expansion to result in poor thermal conducting surface unfavorable for thermal conduction;
□□ The second thermal body (104): It is the active cooling or heating thermal body or passive heat absorbing or releasing thermal body constituted by solid, gaseous, liquid state material or colloidal or powder type matters;

For the thermal conducting principle and device for prestressed-clamping type multi-layered structure of present invention, geometric shapes of the thermal conduction coupling surface between first thermal body (101) and relay thermal conductor (102) as well as the thermal conduction coupling surface between interface thermal conductor (103) and second thermal body (104) can be optionally selected as needed;

The heat resistance between first thermal body (101) and second thermal body (104) is lowered down through said particular structures.

For the thermal conducting principle and device for prestressed-clamping type multi-layered structure relative relationships between first thermal body (101), relay thermal conductor (102), interface thermal conductor (103), and second thermal body (104) are the following:
□□ The thermal conducting or heat dissipating assembled structure (100) is installed between first thermal body (101) and second thermal body (104);
□□ The thermal conducting or heat dissipating assembled structure (100) comprises the thermal conductor being constituted by at least two layers of materials with different thermal characteristics, wherein the relay thermal conductor (102) having a better thermal conductivity coefficient to first thermal body (101) relative to interface thermal conductor (103) is coupled with first thermal body (101), and the interface thermal conductor (103) is coupled between relay thermal conductor (102) and second thermal body (104); the interface thermal conductor (103) has the thermal conducting characteristics with both or one of the 1) higher specific heat capacity relative to relay thermal conductor (102), or 2) better thermal emissivity to second thermal body (104) relative to relay thermal conductor (102);
□□The relay thermal conductor (102) is made of the material having thermal conductivity coefficient better than interface thermal conductor (103);
□□ The interface thermal conductor (103) is made of the material having both or one of thermal conducting characteristic of the specific heat capacity or the thermal emissivity to second thermal body (104) better than the one of relay thermal conductor (102);
□□ The thermal conduction coupling surface area of relay thermal conductor (102) to interface thermal conductor (103) is larger or equal to the thermal conduction coupling surface area between relay thermal conductor (102) and first thermal body (101) thereby reducing the heat resistance;
□□ The thermal conduction coupling surface area of interface thermal conductor (103) to second thermal body (104) is larger or equal to thermal conduction coupling surface area between relay thermal conductor (102) and interface thermal conductor (103) thereby reducing the heat resistance;

In above said structures, if temperature of first thermal body (101) is higher than the one of second thermal body (104), the thermal energy of first thermal body (101) is through the smaller area thermal conduction coupling surface between first thermal body (101) and relay thermal conductor (102) to externally execute diffusive thermal conduction to relay thermal conductor (102) having better thermal conductivity coefficient, thereby by at least one of the following functions to assist the thermal energy conduction, including that: 1) It is through the larger area thermal conduction coupling surface between relay thermal conductor (102) and interface thermal conductor (103) to diffuse thermal energy to interface thermal conductor (103) having larger specific heat capacity; or 2) It is further through the equal or larger area thermal conduction coupling surface of interface thermal conductor (103) to second thermal body (104) to release thermal energy; or 3) It is though the characteristic of better thermal emissivity to release thermal energy to second thermal body (104);

In above said structure, if the temperature of first thermal body (101) is lower than the one of second thermal body (104), the thermal energy of second thermal body (104) is through the larger area thermal conduction coupling surface between second thermal body (104) and interface thermal conductor (103) to diffusely conduct to interface thermal conductor (103) having larger specific heat capacity, and further through the smaller area thermal conduction coupling surface between interface thermal conductor (103) and relay thermal conductor (102) to conduct the thermal energy to relay thermal conductor (102), and further through the smaller area thermal conduction coupling surface of relay thermal conductor (102) having better thermal conductivity coefficient to release thermal energy to first thermal body (101).

For thermal conducting principle and device for prestressed-clamping type multi-layered structure of present invention, its constitution can be further made to the following structures including:
□□ If at least one of the first thermal body (101), or relay thermal conductor (102), or interface thermal conductor (103), or second thermal body (104) is gaseous or liquid state material or colloidal or powder type matters, they can be contained in the container structure, wherein the container structure can be good thermal conductor or non-thermal conductor or the container can be made of material having better thermal conductivity coefficient to constitute relay thermal conductor (102), or the container can be made of material having larger specific heat capacity to constitute the function of interface thermal conductor (103).

For the thermal conducting principle and device for prestressed-clamping type multi-layered structure of present invention, the thermal conduction coupling and combined surface between the relay thermal conductor (102) and the interface thermal conductor (103) can be optionally selected as needed to be one or more than one combined methods as follows including concavely and convexly prestressed-clampingly combined, or prestressed-clampingly dovetailed, or T-slot prestressed-clampingly combined, or prestressed-clampingly combined by stud/hole fastening, or concavely and convexly prestressed-clampingly combined by multi-fins, or prestressed-clampingly combined methods by other conventional heat conducting surface etc. to enlarge the conducting area;

Fig. 1 is a structural schematic view of the present invention showing that the first thermal body being constituted by the thermal conducting casing at heat release end or heat absorbing end of heat pipe is prestressed-clampingly combined.

Fig. 2 is a top schematic view of Fig. 1.

Fig. 3 is a structural schematic view of the present invention showing that the thermal conduction coupling and combined surface between relay thermal conductor (102) and interface thermal conductor (103) is concavely and convexly prestressed-clampingly combined.

Fig. 4 is a structural schematic view of the present invention showing that the thermal conduction coupling and combined surface between relay thermal conductor (102) and interface thermal conductor (103) is prestressed-clampingly combined.

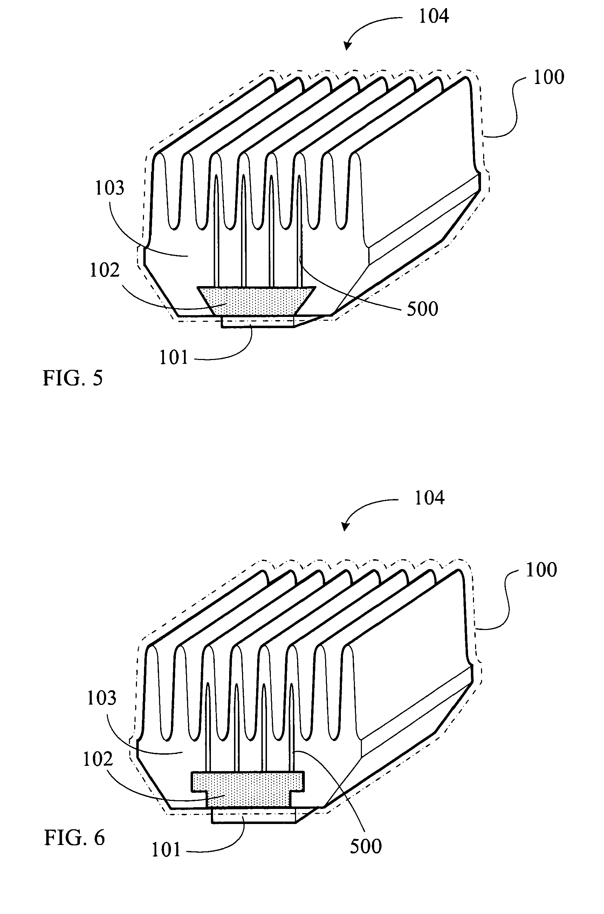

Fig. 5 is a structural schematic view of the present invention showing that the thermal conduction coupling and combined surface between relay thermal conductor (102) and interface thermal conductor (103) is prestressed-clampingly dovetailed.

Fig. 6 is a structural schematic view of the present invention showing that the thermal conduction coupling and combined surface between relay thermal conductor (102) and interface thermal conductor (103) is T-slot prestressed-clampingly combined.

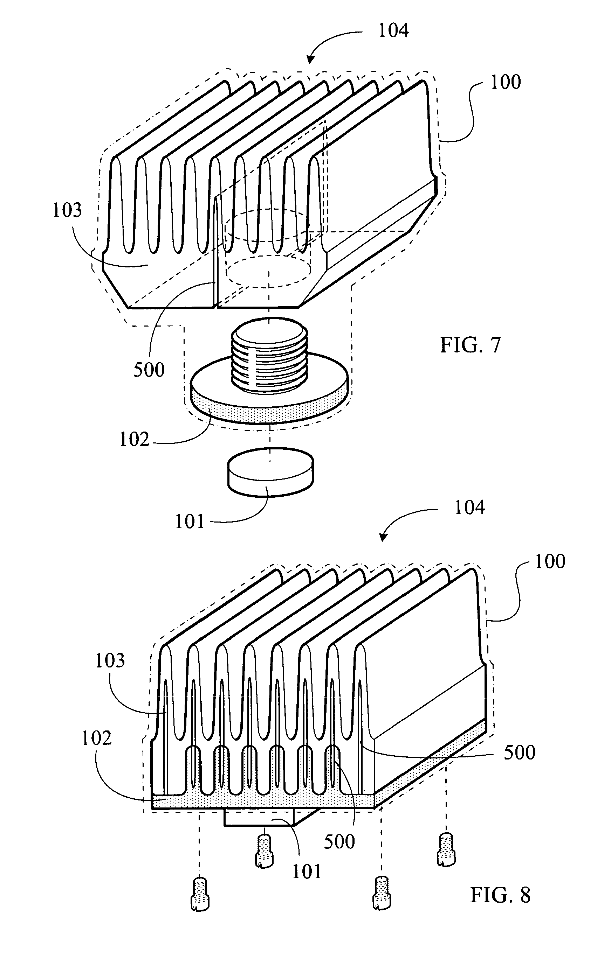

Fig. 7 is a structural schematic view of the present invention showing that the thermal conduction coupling and combined surface between relay thermal conductor (102) and interface thermal conductor (103) is prestressed-clampingly combined by stud/hole fastening.

Fig. 8 is a structural schematic view of the present invention showing that the thermal conduction coupling and combined surface between relay thermal conductor (102) and interface thermal conductor (103) is concavely and convexly prestressed-clampingly combined by multi-fins.

For said thermal conducting principle and device for prestressed-clamping type multi-layered structure, at least one layer of thermal conductive interlayer (110) can be installed between the relay thermal conductor (102) and the interface thermal conductor (103) to appear multi-layer structure, wherein the relationships between the additionally installed thermal conductive interlayer (110), relay thermal conductor (102) and interface thermal conductor (103) are the following:
□□ The specific heat capacity of thermal conductive interlayer (110) is larger than the one of relay thermal conductor (102), but is smaller than the one of interface thermal conductor (103), and if the multi-layered structure of thermal conductive interlayer (110) is adopted, then the specific heat capacity of thermal conductive interlayer (110) is smaller as it is closer to the relay thermal conductor (102), but still larger than the one of relay thermal conductor (102);
□□ The thermal conductivity coefficient of thermal conductive interlayer (110) is better than the one of interface thermal conductor (103), and the thermal conductivity coefficient of relay thermal conductor (102) is better than the one of thermal conductive interlayer (110); when multiple layered structure of thermal conductive interlayer (110) is optionally adopted, wherein thermal conductivity coefficient of thermal conductive interlayer (110) is better as it is closer to the relay thermal conductor (102), but is still less than the one of relay thermal conductor (102);
□□ The thermal conduction coupling surface between relay thermal conductor (102) and thermal conductive interlayer (110) is larger than the thermal conduction coupling surface area between the thermal conductive interlayer (110) and the interface thermal conductor (103), when multi-layered structure of thermal conductive interlayer (110) is optionally adopted, the thermal conduction coupling surface area between the inter-layers are the same or larger as they are closer to the interface thermal conductor (103);

If there are two or more than two of said thermal conductive interlayers (110), then selection of the thermal conductivity coefficient and the specific heat capacity in the thermal characteristics, and selection of the size of thermal conduction coupling area at the two sides of thermal conductive interlayer (110) are based on the structural principle of that thermal conduction area of each layer being combined from first thermal body (101) to relay thermal conductor (102), thermal conductive interlayer (110), interface thermal conductor (103), and to second thermal body (104) are sequentially the same or increased;

Each structure layer is in prestressed-clamping type combined structure to reduce volume and has a prestressed clearance (500) to produce clamping or outwardly expanding prestressing force to ensure good thermal conducting contact, and to avoid loosening or deformation of the multi-layer structure material due to different coefficients of thermal expansion to result in poor thermal conducting surface unfavorable for thermal conduction.

For thermal conducting principle and device for prestressed-clamping type multi-layered structure of present invention, the thermal conduction coupling and combined surface between the relay thermal conductor (102) and the thermal conductive interlayer (110) can be optionally selected as needed to be one or more than one combined methods as follows including concavely and convexly prestressed-clampingly combined, or prestressed-clampingly dovetailed, or T-slot prestressed-clampingly combined, or prestressed-clampingly combined by stud/hole fastening, or concavely and convexly prestressed-clampingly combined by multi-fins, or prestressed-clampingly combined methods by other conventional heat conducting surface etc. to enlarge the conducting area.

For the thermal conducting principle and device for prestressed-clamping type multi-layered structure, the thermal conduction coupling and combined surface between thermal conductive interlayer (110) and interface thermal conductor (103) can be optionally selected as needed to be one or more than one combined methods as follows including concavely and convexly prestressed-clampingly combined, or prestressed-clampingly dovetailed, or T-slot prestressed-clampingly combined, or prestressed-clampingly combined by stud/hole fastening, or concavely and convexly prestressed-clampingly combined by multi-fins, or prestressed-clampingly combined methods by other conventional heat conducting surface etc. to enlarge the conducting area.

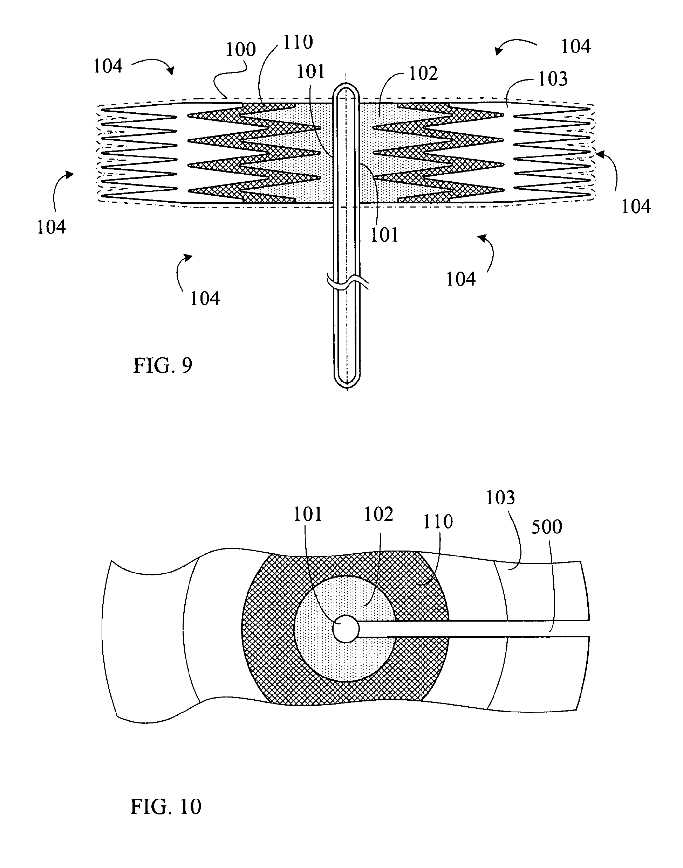

Fig. 9 is a structural schematic view showing the prestressed-clamping structure of the present invention which is installed with thermal conductive interlayer (110), relay thermal conductor (102) and interface thermal conductor (103), and uses the thermal conducting casing at heat release or heat absorbing end of the heat pipe as the first thermal body.

Fig. 10 is a top view of Fig. 9.

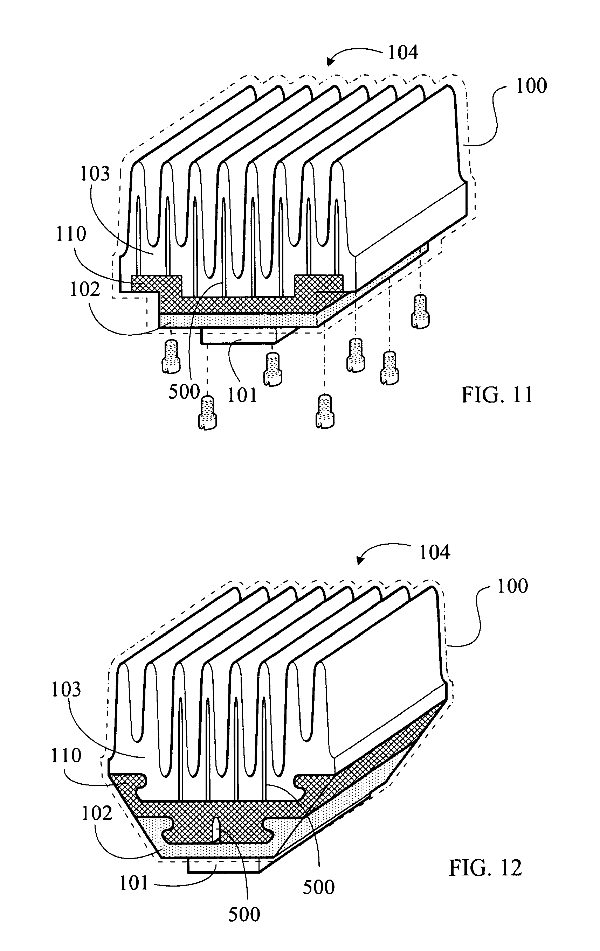

Fig. 11 is a structural schematic view of the present invention showing that the thermal conduction coupling and combined surfaces between thermal conductive interlayer (110) and relay thermal conductor (102) and interface thermal conductor (103) are concavely and convexly prestressed-clampingly combined.

Fig. 12 is a structural schematic view of the present invention showing that the thermal conduction coupling and combined surfaces between thermal conductive interlayer (110) and relay thermal conductor (102) and interface thermal conductor (103) are prestressed-clampingly combined.

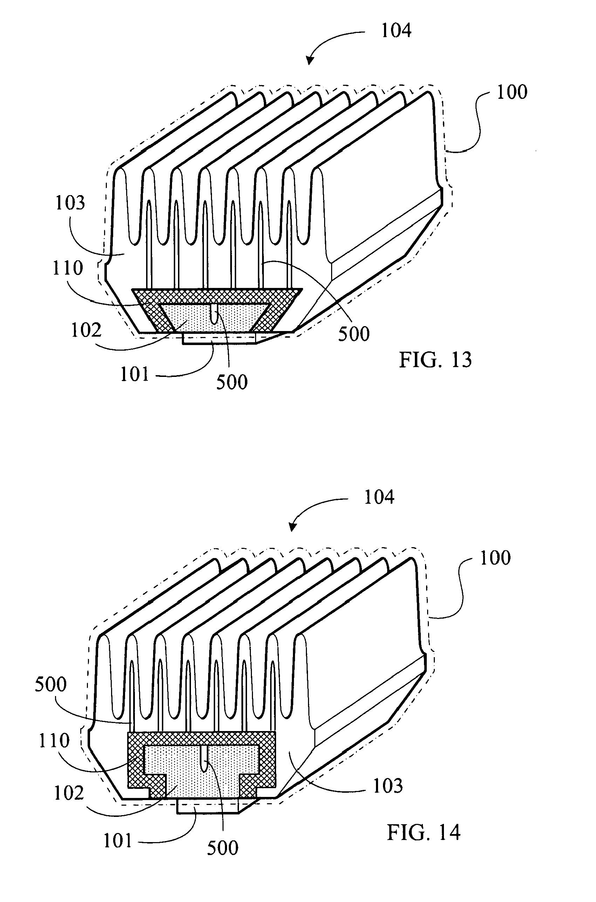

Fig. 13 is a structural schematic view of the present invention showing that the thermal conduction coupling and combined surfaces between thermal conductive interlayer (110) and relay thermal conductor (102) and interface thermal conductor (103) are prestressed-clampingly dovetailed.

Fig. 14 is a structural schematic view of the present invention showing that the thermal conduction coupling and combined surfaces between thermal conductive interlayer (110) and relay thermal conductor (102) and interface thermal conductor (103) are T-slot prestressed-clampingly combined.

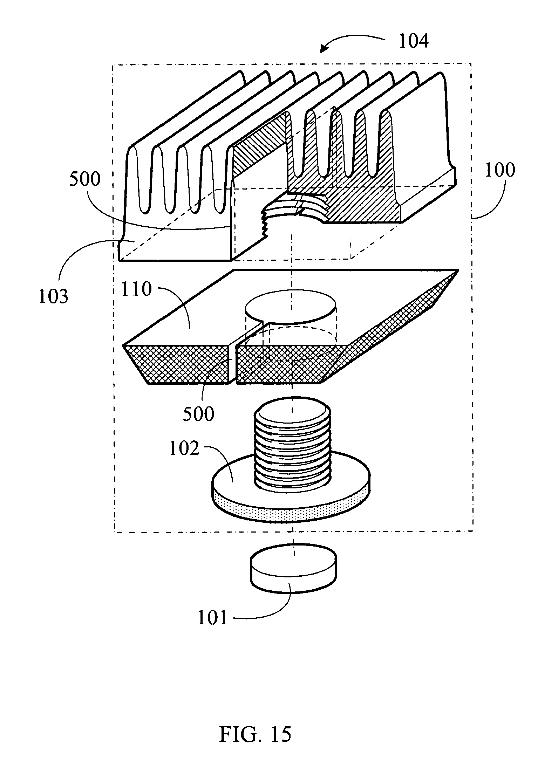

Fig. 15 is a structural schematic view of the present invention showing that the thermal conduction coupling and combined surfaces between thermal conductive interlayer (110) and relay thermal conductor (102) and interface thermal conductor (103) are prestressed-clampingly combined by stud/hole fastening.

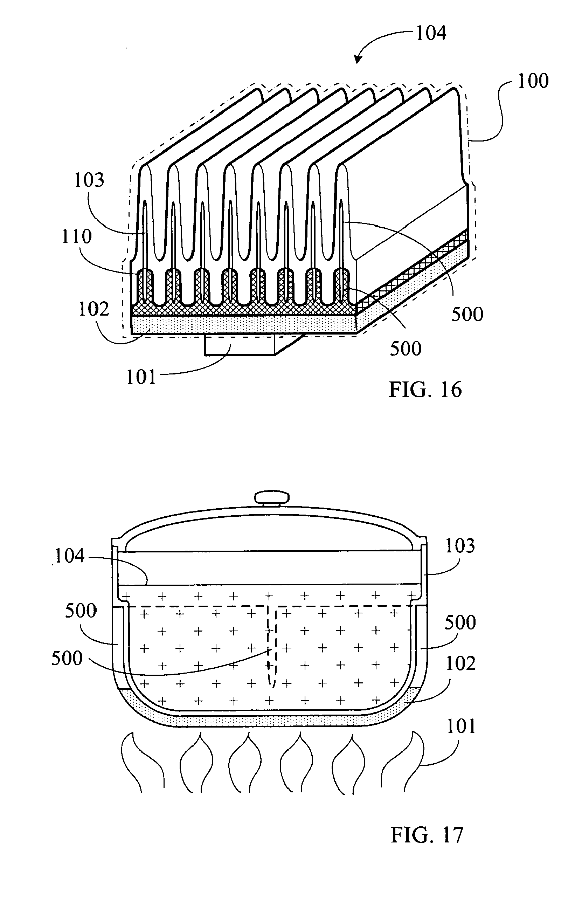

Fig. 16 is a structural schematic view of the present invention showing that the thermal conduction coupling and combined surfaces between thermal conductive interlayer (110) and relay thermal conductor (102) and interface thermal conductor (103) are concavely and convexly prestressed-clampingly combined by multi-fins.

For the thermal conducting principle and device for prestressed-clamping type multi-layered structure of the present invention, if two or more than two layers of thermal conductive interlayer (110) are installed, as shown in the afore Figs. 1∼16, the thermal conduction coupling and combined surface between the at least two layers of thermal conductive interlayer (110) and thermal conductive interlayer (110) can be optionally selected as needed to be one or more than one combined methods as follows including concavely and convexly prestressed-clampingly combined, or prestressed-clampingly dovetailed, or T-slot prestressed-clampingly combined, or prestressed-clampingly combined by stud/hole fastening, or concavely and convexly prestressed-clampingly combined by multi-fins, or prestressed-clampingly combined methods by other conventional heat conducting surface etc. to enlarge the conducting area.

For the thermal conducting principle and device for prestressed-clamping type multi-layered structure of present invention, the thermal conducting or heat dissipating assembled structure (100) can be constituted by first thermal body (101), relay thermal conductor (102), interface thermal conductor (103), second thermal body (104), and/or the thermal conductive interlayer (110) being optionally installed as needed utilizing thermal conductive material in gradually layered structure arranged according to the required thermal conductive characteristics of the multi-layered structure, wherein if all or partially neighboring thermal conductors constituting the thermal conducting or heat dissipating assembled structure (100) are solid state material, and each structure layer is in prestressed-clamping type combined structure to reduce volume and has a prestressed clearance (500) to produce clamping or outwardly expanding prestressing force to ensure good thermal conducting contact and to avoid loosening or deformation of the multi-layer structure material due to different coefficients of thermal expansion to result in poor thermal conducting surface unfavorable for thermal conduction, then the combining methods between the two neighboring thermal conductors include one or more than one of the following:
1. Lockingly combined by external screws and nuts; or
2. Mutually threadly combined by spiral post and spiral hole structure; or
3. Mutually threadly combined by spiral post and spiral hole structure, and is installed with prestressed clearance (500) for prestressed-clamping combination; or
4. Rivetingly fastened; or
5. Pressingly combined; or
6. Clampingly fastened ; or
7. Adhesively combined; or
8. Weldingly combined; or
9. Frictionally fusionly combined; or
10. Neighboring thermal conductors are castedly combined ; or
11. Neighboring thermal conductors are electroplatedly combined; or
12. The thermal conducting structure between neighboring thermal conductors and another thermal conductor are fixedly attachingly combined or translationally attachingly combined; or
13. Neighboring thermal conductors are tightly touchingly combined by gravity; or
14. Neighboring thermal conductors are tightly touchingly combined by attraction of magnet device; or
15. Neighboring thermal conductors are combined as an enclosed structure.

For the thermal conducting principle and device for prestressed-clamping type multi-layered structure of the present invention, the thermal conduction coupling surface between first thermal body (101) and relay thermal conductor (102); or between relay thermal conductor (102) and thermal conductive interlayer (110) if thermal conductive interlayer (110) is installed; or between thermal conductive interlayer (110) and thermal conductive interlayer (110) if multi-layered thermal conductive interlayer (110) is installed; or between thermal conductive interlayer (110) and interface thermal conductor (103); or between relay thermal conductor (102) and interface thermal conductor (103) if thermal conductive interlayer (110) is not installed; or between interface thermal conductor (103) and second thermal body (104) can be combined by one or more than one of the following methods, and each structure layer of neighboring thermal conductors is in prestressed-clamping type combined structure to reduce volume and has a prestressed clearance (500) to produce clamping or outwardly expanding prestressing force to ensure good thermal conducting contact, and to avoid loosening or deformation of the multi-layer structure material due to different coefficients of thermal expansion to result in poor thermal conducting surface unfavorable for thermal conduction as well as combined by one or more than one of the following methods, including:
1. Lockingly combined by external screws and nuts; or
2. Mutually threadly combined by spiral post and spiral hole structure; or
3. Mutually threadly combined by spiral post and spiral hole structure, and is installed with prestressed clearance (500) for elastic combination; or
4. Rivetingly fastened; or
5. Pressingly combined; or
6. Clampingly fastened; or
7. Adhesively combined; or
8. Weldingly combined; or
9. Frictionally fusionly combined; or
10. Neighboring thermal conductors are castedly combined; or
11. Neighboring thermal conductors are electroplatedly combined; or
12. The thermal conducting structure between neighboring thermal conductors and another thermal conductor are fixedly attachingly combined or translationally attachingly combined; or
13. Neighboring thermal conductors are tightly touchingly combined by gravity; or
14. Neighboring thermal conductors are tightly touchingly combined by attraction of magnet device; or
15. Neighboring thermal conductors are combined as an enclosed structure.

If the neighboring thermal conductor of the solid state thermal conductor is constituted by gaseous or liquid state material or colloidal or powder type matters, then the thermal energy conduction of its thermal conduction coupling surface includes one or more one methods of the following:
1. The solid state thermal conductor transfers thermal energy of neighboring gaseous or liquid state material, or colloidal or powder type matters via the heat receiving surface thereof; or
2. The gaseous or liquid state material, or colloidal or powder type matters of higher temperature is pumped by liquid pump or fan to randomly contact with the solid state thermal conductor surface so as to transfer thermal energy to the neighboring solid state thermal conductor;

For the thermal conducting principle and device for prestressed-clamping type multi-layered structure of the present invention, if first thermal body (101) or second thermal body (104) is a combustion state heat source, then heat conducting methods between it and neighboring solid state thermal conducting structure include: the solid state thermal conductor is through its heat receiving surface to transfer thermal energy to neighboring combustion type heat generator.

Fig. 17 is a schematic view of the application example showing that heat receiving surface of relay thermal conductor (102) transfers neighboring cooking device of combustion state heat generator.

For the thermal conducting principle and device for prestressed-clamping type multi-layered structure of present invention, if first thermal body (101) is made of gaseous, liquid state material or colloidal or powder type matters, then its heat conducting methods include: The colloidal or powder type matters being stirred by the stirring mechanism driven by manual, electric or machine power is randomly transfer the thermal energy of colloidal or powder type matters to neighboring solid state thermal conductors.

For the thermal conducting principle and device for prestressed-clamping type multi-layered structure of present invention, the thermal conducting methods between interface thermal conductor (103) and second thermal body (104) include the following:
□□ If the second thermal body (104) is a solid state heat receiver, then the thermal conductive coupling surface between it and the solid state interface thermal conductor (103) can be combined by one or more than one of the following methods; further, each structure layer of the neighboring thermal conductors is in prestressed-clamping combined structure to reduce volume and has a prestressed clearance (500) to produce clamping or outwardly expanding prestressing force to ensure good thermal conducting contact and to avoid loosening or deformation of the multi-layer structure material due to different thermal conductivity coefficients to result in poor thermal conducting surface unfavorable for thermal conduction as well as combined by one or more than one of the following methods, including:
   1. Lockingly combined by external screws and nuts; or
   2. Mutually threadly combined by spiral post and spiral hole structure; or
   3. Mutually threadly combined by spiral post and spiral hole structure, and is installed with prestressed clearance (500) for elastic combination; or
   4. Rivetingly fastened; or
   5. Pressingly combined; or
   6. Clampingly fastened; or
   7. Adhesively combined; or
   8. Weldingly combined; or
   9. Frictionally fusionly combined; or
   10. The second thermal body (104) is castedly combined; or
   11. The second thermal body (104) is electroplatedly combined to interface thermal conductor (103); or
   12. The thermal conducting structure between second thermal body (104) and interface thermal conductor (103) are fixedly attachingly combined or translationally attachingly combined; or
   13. Neighboring thermal conductors are tightly touchingly combined by gravity; or
   14. Neighboring thermal conductors are tightly touchingly combined by attraction of magnet device; or
   15. Neighboring thermal conductors are combined as an enclosed structure;
□□ If second thermal body (104) is gaseous state material, then thermal conductive coupling method between it and the solid state interface thermal conductor (103) include one or more one method of the following:
   1. The thermal energy is transferred by heat receiving surface of solid state interface thermal conductor (103) to gaseous state second thermal body (104); or
   2. The thermal energy is transferred to gaseous state second thermal body (104) blown by fans via interface thermal conductor (103);
□□ If second thermal body (104) is liquid state material, then thermal conductive coupling methods between it and interface thermal conductor (103) include one or more than one methods of the following:
   1. The interface thermal conductor (103) is immersed in liquid state second thermal body (104) for thermal energy conduction by free convection; or
   2. The liquid state second thermal body (104) is conveyed by the pump to pass through the surface of interface thermal conductor (103) for thermal energy conduction with interface thermal conductor (103);
□□ If second thermal body (104) is colloidal or powder type matter, then thermal conductive coupling methods between it and solid state interface thermal conductor (103) include: the colloidal or powder type matters being stirred by the stirring mechanism driven by manual, electric or machine power is randomly passed through interface thermal conductor (103) to transfer thermal energy.

For the Thermal conducting principle and device for prestressed-clamping type multi-layered structure of present invention, one or more than one auxiliary thermal conducting method can be optionally selected to be installed between first thermal body (101) and relay thermal conductor (102); or between relay thermal conductor (102) and interface thermal conductor (103); or between interface thermal conductor (103) and second thermal body (104); or between relay thermal conductor (102) and thermal conductive interlayer (110) if thermal conductive inter-layer (110) installed, or between thermal conductive interlayer (110) and thermal conductive interlayer (110) if multiple layered thermal conductive interlayer (110) is installed; or between thermal conductive interlayer (110) and interface thermal conductor (103), including:
1. To be installed with electrically insulated heat conductive piece; or
2. To be coated with thermally conductive grease; or
3. To be installed with electrically insulated thermal conductive piece and coated with thermally conductive grease.

The thermal conducting principle and device for prestressed-clamping type multi-layered structure of present invention can be applied for various heat absorbing or dissipating, or cooling thermal conductive application devices, such as heat absorption and dissipation of various machine casings, heat pipe structures, structure casings, semiconductor components, ventilation devices, or the heat absorption, heat dissipation or thermal energy conduction of information, audio or image devices, or heat dissipation of various lamp or LED devices, or the heat absorption or dissipation or thermal energy conduction of air conditioning devices, electrical machines or engine, or heat dissipation of thermal energy conduction from frictional heat loss of the mechanical devices, or heat dissipation or thermal energy conduction of electric heater or other electric heating home appliances or cooking devices, or heat absorption or thermal energy conduction of flame heating stoves or cooking devices, or heat absorption, heat dissipation or thermal energy conduction of earth layer or water thermal energy, plant or housing building or building material or building structure devices, heat absorbing or dissipation of water tower, or heat absorption, heat dissipation or thermal energy conduction of batteries of fuel cells, etc;

As well as applied for thermal energy conduction in home appliances, industrial products, electronic products, electrical machines or mechanical devices, power generation equipments, buildings, air conditioning devices, industrial equipments or industrial manufacturing process.

## Claims

1. A thermal conducting principle and device for prestressed-clamping type multi-layered structure, wherein the multi-layered thermal conducting or heat dissipating structure is made of materials with different thermal characteristics and is different from the conventional thermal conducting or heat dissipating structure being made of single material, wherein for the thermal conducting principle and device for prestressed-clamping type multi-layered structure of present invention, the relay thermal conductor being made of material with better thermal conductivity coefficient is heat conductively coupled with the heating or cooling first thermal body at one end or surface thereof, and is coupled with the interface thermal conductor at the other end or surface thereof, and the interface thermal conductor having the thermal conducting characteristics with both or at least one of the 1) higher specific heat capacity relative to relay thermal conductor, or 2) better thermal emissivity to second thermal body relative to relay thermal conductor is used as the heat conducting carrier between relay thermal conductor and second thermal body, and is favorable for thermal energy conduction when there is temperature difference between first thermal body and second thermal body; in addition, the present invention further discloses that each structure layer being in prestressed-clamping type combined structure to reduce volume has the prestressed clearance (500) for producing clamping or outwardly expanding prestressing force to avoid loosening or deformation of the multi-layer structure material due to different coefficients of thermal expansion to result in poor thermal conducting surface unfavorable for thermal conduction.

2. A thermal conducting principle and device for prestressed-clamping type multi-layered structure as claimed in claim 1, wherein it mainly comprises:
□□ The thermal conducting or heat dissipating assembled structure (100) being constituted by at least two layers of thermal conducting material having different thermal characteristics, wherein the relay thermal conductor (102) having better thermal conductivity coefficient is coupled with the first thermal body (101), and the interface thermal conductor (103) having higher thermal capacity is coupled between the relay thermal conductor (102) and the second thermal body (104) thereby constituting the thermal conducting or heat dissipating assembled structure (100);
The thermal conducting or heat dissipating assembled structure (100) is installed between first thermal body (101) and second thermal body (104); wherein thermal conducting or heat dissipating assembled structure (100) is constituted by relay thermal conductor (102) and interface thermal conductor (103), wherein
□□ The first thermal body (101): It is an active cooling or heating, or passive heat absorbing or releasing thermal body constituted by non-closed solid, gaseous, liquid state material or colloidal or powder type matters; or the thermal body being constituted by thermal conducting casing at the heat release end or heat absorbing end of heat pipe;
□□ The relay thermal conductor (102): The relay thermal conductor is constituted by at least one layer of solid, gaseous, liquid state material or colloidal or powder type matters having a better thermal conductivity coefficient, wherein the relay thermal conductor (102) is contact combined with the open first thermal body (101) at one end or surface thereof, and is combined with the interface thermal conductor (103) at the other end or surface thereof for thermal energy conduction includes that the relay thermal conductor (102) is installed between the first thermal body (101) being constituted by the thermal conducting casing at heat release end or heat absorbing end of heat pipe and the interface thermal conductor (103) for thermal energy conduction, or the relay thermal conductor (102) in prestressed-clamping combination is installed between the first thermal body (101) constituted by thermal conducting casing of thermal fluid conducting pipe and the interface thermal conductor (103) for thermal energy conduction; the thermal conductivity coefficient of the relay thermal conductor and the first thermal body (11) is better than the one of the interface thermal conductor (103), i.e. its thermal conducting rate is faster than the one of interface thermal conductor (103), and the thermal conduction coupling surface areas of relay thermal conductor (102) and interface thermal conductor (103) are larger or equal to the thermal conduction coupling surface area of relay thermal conductor (102) and first thermal body (101);
□□ The interface thermal conductor (103): It is constituted by at least one layer of solid, gaseous, liquid state material or colloidal or powder type matters having the thermal conducting characteristics with both or at least one of the 1) specific heat capacity , or 2) thermal emissivity to second thermal body (104), better than the one of the relay thermal conductor (102), wherein the interface thermal conductor (103) being installed between the relay thermal conductor (102) and the second thermal body (104) for thermal energy conduction includes that the first thermal body (101) being constituted by the thermal conducting casing at heat release end or heat absorbing end of heat pipe is installed with the relay thermal conductor (102) in prestressed-clamping combination, and the interface thermal conductor (103) is installed between the relay thermal conductor (102) and the second thermal body (104) for thermal energy conduction; or the first thermal body (101) being constituted by the thermal conducting casing of thermal energy fluid piping is installed with the relay thermal conductor (102), and the interface thermal conductor (103) is installed between the relay thermal conductor (102) and the second thermal body (104) for thermal energy conduction (refer to Fig. 3); the thermal conduction coupling surface area between the interface thermal conductor (103) and the second thermal body (104) is larger or equal to the thermal conduction coupling surface area between the relay thermal conductor (102) and the interface thermal conductor (103);
Each structure layer is in prestressed-clamping type combined structure to reduce volume and has a prestressed clearance (500) to produce clamping or outwardly expanding prestressing force to ensure good thermal conducting contact, and to avoid loosening or deformation of the multi-layer structure material due to different coefficients of thermal expansion to result in poor thermal conducting surface unfavorable for thermal conduction;
□□ The second thermal body (104) : It is the active cooling or heating thermal body or passive heat absorbing or releasing thermal body constituted by solid, gaseous, liquid state material or colloidal or powder type matters;
For the thermal conducting principle and device for prestressed-clamping type multi-layered structure of present invention, geometric shapes of the thermal conduction coupling surface between first thermal body (101) and relay thermal conductor (102) as well as the thermal conduction coupling surface between interface thermal conductor (103) and second thermal body (104) can be optionally selected as needed;
The heat resistance between first thermal body (101) and second thermal body (104) is lowered down through said particular structures.

3. A thermal conducting principle and device for prestressed-clamping type multi-layered structure as claimed in claim 1, wherein the relative relationships between first thermal body (101), relay thermal conductor (102), interface thermal conductor (103), and second thermal body (104) are the following:
□□ The thermal conducting or heat dissipating assembled structure (100) is installed between first thermal body (101)and second thermal body (104);
□□ The thermal conducting or heat dissipating assembled structure (100) comprises the thermal conductor being constituted by at least two layers of materials with different thermal characteristics, wherein the relay thermal conductor (102) having a better thermal conductivity coefficient to first thermal body (101) relative to interface thermal conductor (103) is coupled with first thermal body (101), and the interface thermal conductor (103) is coupled between relay thermal conductor (102) and second thermal body (104); the interface thermal conductor (103) has the thermal conducting characteristics with both or one of the 1) higher specific heat capacity relative to relay thermal conductor (102), or 2) better thermal emissivity to second thermal body (104) relative to relay thermal conductor (102);
□□ The relay thermal conductor (102) is made of the material having thermal conductivity coefficient better than interface thermal conductor (103);
□□ The interface thermal conductor (103) is made of the material having both or one of thermal conducting characteristic of the specific heat capacity or the thermal emissivity to second thermal body (104) better than the one of relay thermal conductor (102);
□□ The thermal conduction coupling surface area of relay thermal conductor (102) to interface thermal conductor (103) is larger or equal to the thermal conduction coupling surface area between relay thermal conductor (102) and first thermal body (101) thereby reducing the heat resistance;
□□The thermal conduction coupling surface area of interface thermal conductor (103) to second thermal body (104) is larger or equal to thermal conduction coupling surface area between relay thermal conductor (102) and interface thermal conductor (103) thereby reducing the heat resistance;
In above said structures, if temperature of first thermal body (101) is higher than the one of second thermal body (104), the thermal energy of first thermal body (101) is through the smaller area thermal conduction coupling surface between first thermal body (101) and relay thermal conductor (102) to externally execute diffusive thermal conduction to relay thermal conductor (102) having better thermal conductivity coefficient, thereby by at least one of the following functions to assist the thermal energy conduction, including that: 1) It is through the larger area thermal conduction coupling surface between relay thermal conductor (102) and interface thermal conductor (103) to diffuse thermal energy to interface thermal conductor (103) having larger specific heat capacity; or 2) It is further through the equal or larger area thermal conduction coupling surface of interface thermal conductor (103) to second thermal body (104) to release thermal energy; or 3) It is though the characteristic of better thermal emissivity to release thermal energy to second thermal body (104);
In above said structure, if the temperature of first thermal body (101) is lower than the one of second thermal body (104), the thermal energy of second thermal body (104) is through the larger area thermal conduction coupling surface between second thermal body (104) and interface thermal conductor (103) to diffusely conduct to interface thermal conductor (103) having larger specific heat capacity, and further through the smaller area thermal conduction coupling surface between interface thermal conductor (103) and relay thermal conductor (102) to conduct the thermal energy to relay thermal conductor (102), and further through the smaller area thermal conduction coupling surface of relay thermal conductor (102) having better thermal conductivity coefficient to release thermal energy to first thermal body (101).

4. A thermal conducting principle and device for prestressed-clamping type multi-layered structure as claimed in claim 1, wherein its constitution can be further made to the following structures including:
If at least one of the first thermal body (101), or relay thermal conductor (102), or interface thermal conductor (103), or second thermal body (104) is gaseous or liquid state material or colloidal or powder type matters, they can be contained in the container structure, wherein the container structure can be good thermal conductor or non-thermal conductor or the container can be made of material having better thermal conductivity coefficient to constitute relay thermal conductor (102), or the container can be made of material having larger specific heat capacity to constitute the function of interface thermal conductor (103).

5. A thermal conducting principle and device for prestressed-clamping type multi-layered structure as claimed in claim 1, wherein the thermal conduction coupling and combined surface between the relay thermal conductor (102) and the interface thermal conductor (103) can be optionally selected as needed to be one or more than one combined methods as follows including concavely and convexly prestressed-clampingly combined, or prestressed-clampingly dovetailed, or T-slot prestressed-clampingly combined, or prestressed-clampingly combined by stud/hole fastening, or concavely and convexly prestressed-clampingly combined by multi-fins, or prestressed-clampingly combined methods by other conventional heat conducting surface etc. to enlarge the conducting area.

6. A thermal conducting principle and device for prestressed-clamping type multi-layered structure, wherein at least one layer of thermal conductive interlayer (110) can be installed between the relay thermal conductor (102) and the interface thermal conductor (103) to appear multi-layer structure, wherein the relationships between the additionally installed thermal conductive interlayer (110), relay thermal conductor (102) and interface thermal conductor (103) are the following:
□□ The specific heat capacity of thermal conductive interlayer (110) is larger than the one of relay thermal conductor (102), but is smaller than the one of interface thermal conductor (103), and if the multi-layered structure of thermal conductive interlayer (110) is adopted, then the specific heat capacity of thermal conductive interlayer (110) is smaller as it is closer to the relay thermal conductor (102), but still larger than the one of relay thermal conductor (102);
□□ The thermal conductivity coefficient of thermal conductive interlayer (110) is better than the one of interface thermal conductor (103), and the thermal conductivity coefficient of relay thermal conductor (102) is better than the one of thermal conductive interlayer (110); when multiple layered structure of thermal conductive interlayer (110) is optionally adopted, wherein thermal conductivity coefficient of thermal conductive interlayer (110) is better as it is closer to the relay thermal conductor (102), but is still less than the one of relay thermal conductor (102);
□□ The thermal conduction coupling surface between relay thermal conductor (102) and thermal conductive interlayer (110) is larger than the thermal conduction coupling surface area between the thermal conductive interlayer (110) and the interface thermal conductor (103), when multi-layered structure of thermal conductive interlayer (110) is optionally adopted, the thermal conduction coupling surface area between the inter-layers are the same or larger as they are closer to the interface thermal conductor (103);
If there are two or more than two of said thermal conductive interlayers (110), then selection of the thermal conductivity coefficient and the specific heat capacity in the thermal characteristics, and selection of the size of thermal conduction coupling area at the two sides of thermal conductive interlayer (110) are based on the structural principle of that thermal conduction area of each layer being combined from first thermal body (101) to relay thermal conductor (102), thermal conductive interlayer (110), interface thermal conductor (103), and to second thermal body (104) are sequentially the same or increased;
Each structure layer is in prestressed-clamping type combined structure to reduce volume and has a prestressed clearance (500) to produce clamping or outwardly expanding prestressing force to ensure good thermal conducting contact.

7. A thermal conducting principle and device for prestressed-clamping type multi-layered structure as claimed in claim 6, wherein the thermal conduction coupling and combined surface between the relay thermal conductor (102) and the thermal conductive interlayer (110) can be optionally selected as needed to be one or more than one combined methods as follows including concavely and convexly prestressed-clampingly combined, or prestressed-clampingly dovetailed, or T-slot prestressed-clampingly combined, or prestressed-clampingly combined by stud/hole fastening, or concavely and convexly prestressed-clampingly combined by multi-fins, or prestressed-clampingly combined methods by other conventional heat conducting surface etc. to enlarge the conducting area.

8. A thermal conducting principle and device for prestressed-clamping type multi-layered structure as claimed in claim 6, wherein the thermal conduction coupling and combined surface between thermal conductive interlayer (110) and interface thermal conductor (103) can be optionally selected as needed to be one or more than one combined methods as follows including concavely and convexly prestressed-clampingly combined, or prestressed-clampingly dovetailed, or T-slot prestressed-clampingly combined, or prestressed-clampingly combined by stud/hole fastening, or concavely and convexly prestressed-clampingly combined by multi-fins, or prestressed-clampingly combined methods by other conventional heat conducting surface etc. to enlarge the conducting area.

9. A thermal conducting principle and device for prestressed-clamping type multi-layered structure as claimed in claim 6, wherein if two or more than two layers of thermal conductive interlayer (110) are installed, the thermal conduction coupling and combined surface between the at least two layers of thermal conductive interlayer (110) and thermal conductive interlayer (110) can be optionally selected as needed to be one or more than one combined methods as follows including concavely and convexly prestressed-clampingly combined, or prestressed-clampingly dovetailed, or T-slot prestressed-clampingly combined, or prestressed-clampingly combined by stud/hole fastening, or concavely and convexly prestressed-clampingly combined by multi-fins, or prestressed-clampingly combined methods by other conventional heat conducting surface etc. to enlarge the conducting area.

10. A thermal conducting principle and device for prestressed-clamping type multi-layered structure as claimed in claim 2 or 6, wherein the thermal conducting or heat dissipating assembled structure (100) can be constituted by first thermal body (101), relay thermal conductor (102), interface thermal conductor (103), second thermal body (104), and/or the thermal conductive interlayer (110) being optionally installed as needed utilizing thermal conductive material in gradually layered structure arranged according to the required thermal conductive characteristics of the multi-layered structure, wherein if all or partially neighboring thermal conductors constituting the thermal conducting or heat dissipating assembled structure (100) are solid state material, and each structure layer is in prestressed-clamping type combined structure to reduce volume and has a prestressed clearance (500) to produce clamping or outwardly expanding prestressing force to ensure good thermal conducting contact, then the combining methods between the two neighboring thermal conductors include one or more than one of the following:
1. Lockingly combined by external screws and nuts; or
2. Mutually threadly combined by spiral post and spiral hole structure; or
3. Mutually threadly combined by spiral post and spiral hole structure, and is installed with prestressed clearance (500) for prestressed-clamping combination; or
4. Rivetingly fastened; or
5. Pressingly combined; or
6. Clampingly fastened ; or
7. Adhesively combined; or
8. Weldingly combined; or
9. Frictionally fusionly combined; or
10. Neighboring thermal conductors are castedly combined; or
11. Neighboring thermal conductors are electroplatedly combined; or
12. The thermal conducting structure between neighboring thermal conductors and another thermal conductor are fixedly attachingly combined or translationally attachingly combined; or
13. Neighboring thermal conductors are tightly touchingly combined by gravity; or
14. Neighboring thermal conductors are tightly touchingly combined by attraction of magnet device; or
15. Neighboring thermal conductors are combined as an enclosed structure.

11. A thermal conducting principle and device for prestressed-clamping type multi-layered structure as claimed in claim 2 or 6, wherein the thermal conduction coupling surface between first thermal body (101) and relay thermal conductor (102); or between relay thermal conductor (102) and thermal conductive interlayer (110) if thermal conductive interlayer (110) is installed; or between thermal conductive interlayer (110) and thermal conductive interlayer (110) if multi-layered thermal conductive interlayer (110) is installed; or between thermal conductive interlayer (110) and interface thermal conductor (103); or between relay thermal conductor (102) and interface thermal conductor (103) if thermal conductive interlayer (110) is not installed; or between interface thermal conductor (103) and second thermal body (104) can be combined by one or more than one of the following methods, and each structure layer of neighboring thermal conductors is in prestressed-clamping type combined structure to reduce volume and has a prestressed clearance (500) to produce clamping or outwardly expanding prestressing force to ensure good thermal conducting contact, and combined by one or more than one of the following methods, including:
1. Lockingly combined by external screws and nuts; or
2. Mutually threadly combined by spiral post and spiral hole structure; or
3. Mutually threadly combined by spiral post and spiral hole structure, and is installed with prestressed clearance (500) for elastic combination; or
4. Rivetingly fastened; or
5. Pressingly combined; or
6. Clampingly fastened; or
7. Adhesively combined; or
8. Weldingly combined; or
9. Frictionally fusionly combined; or
10. Neighboring thermal conductors are castedly combined; or
11. Neighboring thermal conductors are electroplatedly combined; or
12. The thermal conducting structure between neighboring thermal conductors and another thermal conductor are fixedly attachingly combined or translationally attachingly combined; or
13. Neighboring thermal conductors are tightly touchingly combined by gravity; or
14. Neighboring thermal conductors are tightly touchingly combined by attraction of magnet device; or
15. Neighboring thermal conductors are combined as an enclosed structure;
If the neighboring thermal conductor of the solid state thermal conductor is constituted by gaseous or liquid state material, or colloidal or powder type matters, then the thermal energy conduction of its thermal conduction coupling surface includes one or more one methods of the following:
1. The solid state thermal conductor transfers thermal energy of neighboring gaseous or liquid state material, or colloidal or powder type matters via the heat receiving surface thereof; or
2. The gaseous or liquid state material, or colloidal or powder type matters of higher temperature is pumped by liquid pump or fan to randomly contact with the solid state thermal conductor surface so as to transfer thermal energy to the neighboring solid state thermal conductor.

12. A thermal conducting principle and device for prestressed-clamping type multi-layered structure as claimed in claim 2 or 6, wherein if first thermal body (101) or second thermal body (104) is a combustion state heat source, then heat conducting methods between it and neighboring solid state thermal conducting structure include: the solid state thermal conductor is through its heat receiving surface to transfer thermal energy to neighboring combustion type heat generator.

13. A thermal conducting principle and device for prestressed-clamping type multi-layered structure as claimed in claim 2 or 6, wherein if first thermal body (101) is made of gaseous, liquid state material or colloidal or powder type matters, then its heat conducting methods include: the colloidal or powder type matters being stirred by the stirring mechanism driven by manual, electric or machine power is randomly transfer the thermal energy of colloidal or powder type matters to neighboring solid state thermal conductors.

14. A thermal conducting principle and device for prestressed-clamping type multi-layered structure as claimed in claim 2 or 6, wherein the thermal conducting methods between interface thermal conductor (103) and second thermal body (104) include the following:
□□ If the second thermal body (104) is a solid state heat receiver, then the thermal conductive coupling surface between it and the solid state interface thermal conductor (103) can be combined by one or more than one of the following methods; further, each structure layer of the neighboring thermal conductors is in prestressed-clamping combined structure to reduce volume and has a prestressed clearance (500) to produce clamping or outwardly expanding prestressing force to ensure good thermal conducting contact and to avoid loosening or deformation of the multi-layer structure material due to different thermal conductivity coefficients to result in poor thermal conducting surface unfavorable for thermal conduction as well as combined by one or more than one of the following methods, including:
1. Lockingly combined by external screws and nuts; or
2. Mutually threadly combined by spiral post and spiral hole structure; or
3. Mutually threadly combined by spiral post and spiral hole structure, and is installed with prestressed clearance (500) for elastic combination; or
4. Rivetingly fastened; or
5. Pressingly combined; or
6. Clampingly fastened; or
7. Adhesively combined; or
8. Weldingly combined; or
9. Frictionally fusionly combined; or
10. The second thermal body (104) is castedly combined; or
11. The second thermal body (104) is electroplatedly combined to interface thermal conductor (103); or
12. The thermal conducting structure between second thermal body (104) and interface thermal conductor (103) are fixedly attachingly combined or translationally attachingly combined; or
13. Neighboring thermal conductors are tightly touchingly combined by gravity; or
14. Neighboring thermal conductors are tightly touchingly combined by attraction of magnet device; or
15. Neighboring thermal conductors are combined as an enclosed structure;
□□ If second thermal body (104) is gaseous state material, then thermal conductive coupling method between it and the solid state interface thermal conductor (103) include one or more one method of the following:
1. The thermal energy is transferred by heat receiving surface of solid state interface thermal conductor (103) to gaseous state second thermal body (104); or
2. The thermal energy is transferred to gaseous state second thermal body (104) blown by fans via interface thermal conductor (103);
□□ If second thermal body (104) is liquid state material, then thermal conductive coupling methods between it and interface thermal conductor (103) include one or more than one methods of the following:
1. The interface thermal conductor (103) is immersed in liquid state second thermal body (104) for thermal energy conduction by free convection; or
2. The liquid state second thermal body (104) is conveyed by the pump to pass through the surface of interface thermal conductor (103) for thermal energy conduction with interface thermal conductor (103);
□□ If second thermal body (104) is colloidal or powder type matter, then thermal conductive coupling methods between it and solid state interface thermal conductor (103) include: the colloidal or powder type matters being stirred by the stirring mechanism driven by manual, electric or machine power is randomly passed through interface thermal conductor (103) to transfer thermal energy.

15. A thermal conducting principle and device for prestressed-clamping type multi-layered structure as claimed in claim 2 or 6, wherein one or more than one auxiliary thermal conducting method can be optionally selected to be installed between first thermal body (101) and relay thermal conductor (102); or between relay thermal conductor (102) and interface thermal conductor (103); or between interface thermal conductor (103) and second thermal body (104); or between relay thermal conductor (102) and thermal conductive interlayer (110) if thermal conductive inter-layer (110) installed, or between thermal conductive interlayer (110) and thermal conductive interlayer (110) if multiple layered thermal conductive interlayer (110) is installed; or between thermal conductive interlayer (110) and interface thermal conductor (103), including:
1. To be installed with electrically insulated heat conductive piece; or
2. To be coated with thermally conductive grease; or
3. To be installed with electrically insulated thermal conductive piece and coated with thermally conductive grease.

16. A thermal conducting principle and device for prestressed-clamping type multi-layered structure as claimed in claim 2 or 6, wherein it can be applied for various heat absorbing or dissipating, or cooling thermal conductive application devices, such as heat absorption and dissipation of various machine casings, heat pipe structures, structure casings, semiconductor components, ventilation devices, or the heat absorption, heat dissipation or thermal energy conduction of information, audio or image devices, or heat dissipation of various lamp or LED devices, or the heat absorption or dissipation or thermal energy conduction of air conditioning devices, electrical machines or engine, or heat dissipation of thermal energy conduction from frictional heat loss of the mechanical devices, or heat dissipation or thermal energy conduction of electric heater or other electric heating home appliances or cooking devices, or heat absorption or thermal energy conduction of flame heating stoves or cooking devices, or heat absorption, heat dissipation or thermal energy conduction of earth layer or water thermal energy, plant or housing building or building material or building structure devices, heat absorbing or dissipation of water tower, or heat absorption, heat dissipation or thermal energy conduction of batteries of fuel cells, etc;
As well as applied for thermal energy conduction in home appliances, industrial products, electronic products, electrical machines or mechanical devices, power generation equipments, buildings, air conditioning devices, industrial equipments or industrial manufacturing process.
